# EUROPEAN PATENT APPLICATION

(11) **EP 4 672 338 A1**
(43) Date of publication of application: **31.12.2025**
(21) Application number: 23928394.8
(22) Date of filing: 29.11.2023
(51) Int. Cl.: H01L 27/146, H04N 23/12

(54) **IMAGE SENSOR, IMAGE ACQUISITION METHOD, AND ELECTRONIC DEVICE**

(30) Priority: 21.03.2023 CN 202310311997
(71) Applicant: Huawei Technologies Co., Ltd., Shenzhen, Guangdong 518129 (CN)
(72) Inventor: XIE, Chengzhi, Shenzhen, Guangdong 518129 (CN); ZHANG, Bin, Shenzhen, Guangdong 518129 (CN)
(74) Representative: Goddar, Heinz J.
(86) International application number: PCT/CN2023/135238
(87) International publication number: WO 2024/193090

(57) **Abstract**

Embodiments of this application provide an image sensor, an image capturing method, and an electronic device, and relate to the field of image detection technologies. The image sensor includes a pixel array structure and a processing circuit. The pixel array structure includes a first photosensitive device, a first pixel circuit, a second photosensitive device, a second pixel circuit, and an isolation structure. A plurality of first photosensitive devices are arranged in an array, and the first pixel circuit is electrically connected to the first photosensitive device. A plurality of second photosensitive devices are arranged in an array, and the second pixel circuit is electrically connected to the second photosensitive device. The first photosensitive device and the second photosensitive device are adjacently disposed, and the isolation structure is disposed between the first photosensitive device and the second photosensitive device. A structure of the first photosensitive device is different from a structure of the second photosensitive device, and the first pixel circuit and the second pixel circuit are electrically connected to the processing circuit separately. The image sensor may be used in an image capturing apparatus, to implement image detection.

## Description

This application claims priority to Chinese Patent Application No. 202310311997.1, filed with the China National Intellectual Property Administration on March 21, 2023 and entitled "IMAGE SENSOR, IMAGE CAPTURING METHOD, AND ELECTRONIC DEVICE", which is incorporated herein by reference in its entirety.

### TECHNICAL FIELD

This application relates to the field of image detection technologies, and in particular, to an image sensor, an image capturing method, and an electronic device.

### BACKGROUND

As one of core sensors for human perception of the world, an image sensor has been playing an important role in the human society. With development from a conventional charge-coupled device (Charge-Coupled Device, CCD) image sensor to a complementary metal oxide semiconductor image sensor (CMOS Image Sensor, CIS), preparation costs and detection noise of the image sensor are reduced, and detection performance is greatly improved.

The image sensor may be used in a camera to implement image detection. Core performance of the image sensor includes low-illumination performance and a high dynamic range (High Dynamic Range, HDR). The low-illumination performance refers to a light detection capability of the image sensor in a low light intensity. The high dynamic range refers to a large difference between a maximum light intensity and a minimum light intensity that are simultaneously detected in a same frame of image.

In fields such as the security protection field and the vehicle-mounted field, a requirement on the low-illumination performance and the high dynamic range of the image sensor is high. Therefore, how to improve the low-illumination performance of the image sensor while enabling the image sensor to have the high dynamic range becomes an urgent problem to be resolved in this field.

### SUMMARY

Embodiments of this application provide an image sensor, an image capturing method, and an electronic device, to improve low-illumination performance of the image sensor and enable the image sensor to have a high dynamic range.

To achieve the foregoing objectives, the following technical solutions are used in embodiments of this application.

According to a first aspect, an image sensor is provided. The image sensor includes a pixel array structure and a processing circuit. The pixel array structure includes a first photosensitive device, a first pixel circuit, a second photosensitive device, a second pixel circuit, and an isolation structure. A plurality of first photosensitive devices are arranged in an array, and the first pixel circuit is electrically connected to the first photosensitive device. A plurality of second photosensitive devices are arranged in an array, and the second pixel circuit is electrically connected to the second photosensitive device. The first photosensitive device and the second photosensitive device are adjacently disposed, and the isolation structure is disposed between the first photosensitive device and the second photosensitive device.

A structure of the first photosensitive device is different from a structure of the second photosensitive device, and the first pixel circuit and the second pixel circuit are electrically connected to the processing circuit separately.

The image sensor provided in the foregoing embodiments of this application includes the first photosensitive device, the first pixel circuit, the second photosensitive device, the second pixel circuit, and the processing circuit. When the first photosensitive device includes a single photon avalanche diode, the single photon avalanche diode has a strong light detection capability in an environment with a low illumination range, and is applicable to detecting light in the low illumination range. This helps improve low-illumination performance of the image sensor.

When the second photosensitive device includes a photodiode, the photodiode has a strong light detection capability in an environment with a high illumination range, and is applicable to detecting light in the high illumination range. A combination of the two types of photosensitive devices makes the image sensor have a high dynamic range and improves a capability of the image sensor to detect all ambient light.

In addition, the isolation structure is disposed between the first photosensitive device and the second photosensitive device. The isolation structure may block photon and charge migration between the first photosensitive device and the second photosensitive device, to avoid particle-level crosstalk between the first photosensitive device and the second photosensitive device, and further improve low-illumination performance and a dynamic range of the image sensor.

In some embodiments, the first photosensitive device includes a single photon avalanche diode, and the second photosensitive device includes a photodiode or a quantum dot image sensor.

In some embodiments, the plurality of first photosensitive devices are adjacently disposed, and the isolation structure is further disposed between the adjacent first photosensitive devices, so that the adjacent first photosensitive devices may be separated, to avoid particle-level crosstalk between the first photosensitive devices.

In some embodiments, the isolation structure includes a doping layer and an isolation layer that are arranged in a first direction, and the first direction is a direction from the first photosensitive device to the second photosensitive device.

In the foregoing embodiments, the isolation structure includes the doping layer and the isolation layer, and an isolation capability of the isolation structure is improved by disposing a plurality of layer structures.

In some embodiments, the isolation structure includes two doping layers and one isolation layer that are arranged in the first direction, and the two doping layers are respectively located on two sides of the isolation layer, to further improve the isolation capability of the isolation structure.

In some embodiments, a material of the isolation layer includes a dielectric material, and the dielectric material includes at least one of silicon oxide, silicon nitride, silicon oxynitride, hafnium oxide, and aluminum oxide. In addition/Alternatively, the material of the isolation layer includes a metal material, and the metal material includes at least one of Au, Ti, Al, W, Cu, Ni, Pt, and Pd.

In some embodiments, each first photosensitive device is surrounded by the plurality of second photosensitive devices, and each second photosensitive device is surrounded by the plurality of first photosensitive devices.

In the foregoing disposing manner, the first photosensitive devices and the second photosensitive devices are nested in each other, and are periodically and regularly arranged, so that the plurality of first photosensitive devices in the image sensor are evenly arranged, and the plurality of second photosensitive devices are evenly arranged. This helps improve detection precision of the image sensor for light in each illumination range.

In some embodiments, the pixel array structure includes a plurality of first photoelectric detection pixel structures and a plurality of second photoelectric detection pixel structures. Each first photoelectric detection pixel structure includes one first photosensitive device. Alternatively, each first photoelectric detection pixel structure includes a plurality of first photosensitive devices. Each second photoelectric detection pixel structure includes one second photosensitive device.

It may be understood that, compared with the second photoelectric detection pixel structure, the first photoelectric detection pixel structure has a stronger light detection capability in the environment with the low illumination range. Based on this, increasing a quantity of first photosensitive devices in each first photoelectric detection pixel structure helps improve low-illumination performance of the image sensor.

In some embodiments, the image sensor includes a first chip and a second chip that are disposed in a stacked manner, and the processing circuit includes an image signal processing circuit. The first photosensitive device, the first pixel circuit, the second photosensitive device, and the second pixel circuit are disposed on the first chip, and the image signal processing circuit is disposed on the second chip.

Alternatively, the first photosensitive device and the second photosensitive device are disposed on the first chip, and the first pixel circuit, the second pixel circuit, and the image signal processing circuit are disposed on the second chip.

In some embodiments, the processing circuit further includes a first signal preprocessing circuit, a second signal preprocessing circuit, and an output interface. The first signal preprocessing circuit, the second signal preprocessing circuit, and the output interface are disposed on the second chip.

The first photosensitive device, the first pixel circuit, the first signal preprocessing circuit, the image signal processing circuit, and the output interface are electrically connected in sequence, and the second photosensitive device, the second pixel circuit, the second signal preprocessing circuit, the image signal processing circuit, and the output interface are electrically connected in sequence.

Alternatively, the first photosensitive device, the first pixel circuit, the first signal preprocessing circuit, and the output interface are electrically connected in sequence, and the second photosensitive device, the second pixel circuit, the second signal preprocessing circuit, the image signal processing circuit, and the output interface are electrically connected in sequence.

In some embodiments, the image sensor further includes a plurality of optical lenses, the plurality of optical lenses are disposed on a side that is of the first chip and that is away from the second chip, each first photoelectric detection pixel structure includes one first photosensitive device, each first photosensitive device corresponds to one optical lens, and each second photosensitive device corresponds to one optical lens.

In the foregoing embodiments, the optical lens may be configured to converge light, so that more light is incident to the first photoelectric detection pixel structure and the second photoelectric detection pixel structure. This helps increase light detection amounts of the first photosensitive device and the second photosensitive device.

In some embodiments, each first photoelectric detection pixel structure includes a plurality of first photosensitive devices, the plurality of first photosensitive devices correspond to one optical lens, and each second photosensitive device corresponds to one optical lens.

A plurality of first photosensitive devices in a same first photoelectric detection pixel structure correspond to one optical lens, and the optical lens may be configured to converge light, so that more light is incident to the first photoelectric detection pixel structure and the second photoelectric detection pixel structure. This helps increase light detection amounts of the first photosensitive device and the second photosensitive device.

Alternatively, each first photoelectric detection pixel structure includes a plurality of first photosensitive devices, and each first photosensitive device corresponds to one optical lens. Each first photosensitive device corresponds to one optical lens, so that a light detection amount of each first photosensitive device may be further improved.

In some embodiments, the image sensor further includes a plurality of color filter layers, and the plurality of color filter layers are disposed on the side that is of the first chip and that is away from the second chip. Each first photoelectric detection pixel structure includes one first photosensitive device, each first photosensitive device corresponds to one color filter layer, and each second photosensitive device corresponds to one color filter layer.

In the foregoing embodiments, the color filter layer may be configured to filter out specific color light from ambient light, so that the color light can be incident through the color filter layer, to be detected by the first photosensitive device and the second photosensitive device. A processor receives a digital image signal from the image sensor, to control a display apparatus to display a color image.

In some embodiments, each first photoelectric detection pixel structure includes a plurality of first photosensitive devices, each first photosensitive device corresponds to one color filter layer, and each second photosensitive device corresponds to one color filter layer.

The color filter layer may be configured to filter specific color light from ambient light, so that the color light can be incident through the color filter layer, to be detected by each first photosensitive device and each second photosensitive device. A processor receives a digital image signal from the image sensor, to control a display apparatus to display a color image.

Alternatively, each first photoelectric detection pixel structure includes a plurality of first photosensitive devices, and the plurality of first photosensitive devices correspond to one color filter layer, so that the plurality of first photosensitive devices detect color light from the same color filter layer.

In some embodiments, colors of the plurality of color filter layers include red, green, and blue, and the plurality of color filter layers are disposed in a Bayer array. Alternatively, colors of the plurality of color filter layers include red, yellow, and blue.

According to a second aspect, an image capturing method is provided. The image capturing method may be applied to the image sensor in any one of the foregoing embodiments. The image capturing method includes: The first photosensitive device receives light, and generates and outputs a first electrical signal to the first pixel circuit. The second photosensitive device receives light, and generates and outputs a second electrical signal to the second pixel circuit.

According to the image capturing method provided in the foregoing embodiments of this application, the first photosensitive device receives the light, and generates and outputs the first electrical signal to the first pixel circuit. When the first photosensitive device includes a single photon avalanche diode, the single photon avalanche diode has a strong light detection capability in an environment with a low illumination range, and is applicable to detecting light in the low illumination range. This helps improve low-illumination performance of the image sensor.

In addition, the second photosensitive device receives the light, and generates and outputs the second electrical signal to the second pixel circuit. When the second photosensitive device includes a photodiode, the photodiode has a strong light detection capability in an environment with a high illumination range, and is applicable to detecting light in the high illumination range. A combination of the two types of photosensitive devices makes the image sensor have a high dynamic range and improves a capability of the image sensor to detect all ambient light.

In some embodiments, the processing circuit includes the first signal preprocessing circuit and the second signal preprocessing circuit. The first signal preprocessing circuit is electrically connected to the first pixel circuit, and the second signal preprocessing circuit is electrically connected to the second pixel circuit. The image capturing method further includes: The first signal preprocessing circuit receives the first electrical signal from the first pixel circuit, and generates and outputs a first digital signal. The second signal preprocessing circuit receives the second electrical signal from the second pixel circuit, and generates and outputs a second digital signal.

In some embodiments, the processing circuit further includes the image signal processing circuit and the output interface. Both the first signal preprocessing circuit and the second signal preprocessing circuit are electrically connected to the image signal processing circuit. The image signal processing circuit is electrically connected to the output interface. The image capturing method further includes: The image signal processing circuit filters the first digital signal to generate a first digital image signal, and the output interface receives the first digital image signal. The image signal processing circuit filters the second digital signal to generate a second digital image signal, and the output interface receives and outputs the second digital image signal.

In the foregoing embodiments, the image signal processing circuit may filter the first digital signal to generate the first digital image signal, and filter the second digital signal to generate the second digital image signal, to reduce noise in the first digital image signal and the second digital image signal.

The output interface is configured to receive the first digital image signal from the image signal processing circuit, and output the first digital image signal. The output interface is further configured to receive the second digital image signal from the image signal processing circuit, and output the second digital image signal.

In some embodiments, the first signal preprocessing circuit is directly connected to the output interface, and the second signal preprocessing circuit, the image signal processing circuit, and the output interface are electrically connected in sequence. The image capturing method further includes: The output interface receives and outputs the first digital signal, where the first digital signal includes a first digital image signal. The image signal processing circuit filters the second digital signal to generate a second digital image signal, and the output interface receives and outputs the second digital image signal.

When the first signal preprocessing circuit includes a counter, the first digital signal is generated in a manner of counting by the counter, and conversion from an analog signal to a digital signal is not required. Therefore, the first digital signal has low noise, and does not need to be filtered by the image signal processing circuit, and the first digital signal may be directly output as the first digital image signal.

The image signal processing circuit may compile or filter the second digital signal, to generate the second digital image signal, so as to reduce noise in the second digital image signal. The output interface is configured to receive the second digital image signal from the image signal processing circuit, and output the second digital image signal.

According to a third aspect, an electronic device is provided, where the electronic device includes the image sensor in any one of the foregoing embodiments and a processor, and the image sensor is electrically connected to the processor.

It may be understood that, for beneficial effect that can be achieved by the electronic device provided in the foregoing embodiments of this application, refer to the foregoing beneficial effect of the image sensor. Details are not described herein again.

### BRIEF DESCRIPTION OF DRAWINGS

To describe technical solutions in this application more clearly, the following briefly describes accompanying drawings used for describing some embodiments of this application. It is clear that the accompanying drawings in the following descriptions are merely accompanying drawings in some embodiments of this application. A person of ordinary skill in the art may further derive other drawings from these accompanying drawings. In addition, the accompanying drawings in the following descriptions may be considered as diagrams, and are not intended to limit an actual size of a product, an actual procedure of a method, an actual time sequence of a signal, and the like in embodiments of this application.
FIG. 1 is a diagram of a structure of an electronic device according to an embodiment of this application;
FIG. 2 is a diagram of a planar structure of an image sensor according to an embodiment of this application;
FIG. 3 is a sectional view of the image sensor in FIG. 2 along a section line A-A';
FIG. 4 is a brief diagram of a structure of the image sensor in FIG. 3;
FIG. 5 is a brief diagram of a structure of another image sensor according to an embodiment of this application;
FIG. 6 to FIG. 8 are block diagrams of structures of a plurality of image sensors according to an embodiment of this application;
FIG. 9 is a diagram of a planar structure of another image sensor according to an embodiment of this application;
FIG. 10 is a sectional view of the image sensor in FIG. 9 along a section line B-B';
FIG. 11 is a diagram of a planar structure of another image sensor according to an embodiment of this application;
FIG. 12 is a sectional view of the image sensor in FIG. 11 along a section line C-C';
FIG. 13 is another sectional view of the image sensor in FIG. 11 along a section line C-C';
FIG. 14 is a diagram of a high dynamic range result of an image sensor according to an embodiment of this application;
FIG. 15 is a flowchart of an image capturing method according to an embodiment of this application; and
FIG. 16 is another flowchart of an image capturing method according to an embodiment of this application.

### DESCRIPTION OF EMBODIMENTS

The following clearly describes technical solutions in some embodiments of this application with reference to accompanying drawings. It is clear that the described embodiments are merely some rather than all of embodiments of this application. All other embodiments obtained by a person of ordinary skill in the art based on embodiments of this application shall fall within the protection scope of this application.

In descriptions of this application, it should be understood that directions or position relationships indicated by the terms such as "center", "up", "down", "front", "rear", "left", "right", "vertical", "horizontal", "top", "bottom", "inside", and "outside" are based on the directions or the position relationships shown in the accompanying drawings, and are merely intended to describe this application and simplify the descriptions, but not intended to indicate or imply that an indicated apparatus or component shall have a specific direction or be formed and operated in a specific direction, and therefore cannot be understood as a limitation on this application.

Unless otherwise required by the context, throughout the specification and claims, the term "include" is interpreted as "open and inclusive", that is, "include but not limited to". In the description of the specification, terms such as "an embodiment", "some embodiments", "example embodiments", "examples", or "some examples" are intended to indicate that specific features, structures, materials, or characteristics related to the embodiments or examples are included in at least one embodiment or example of this application. The foregoing schematic representations of the terms do not necessarily refer to a same embodiment or example. Further, the specific feature, structure, material, or characteristic may be included in any one or more embodiments or examples in any appropriate manner.

The terms "first" and "second" mentioned below are merely intended for a purpose of description, and shall not be understood as an indication or implication of relative importance or implicit indication of the number of indicated technical features. Therefore, a feature limited by "first" or "second" may explicitly or implicitly include one or more features. In the descriptions of embodiments of this application, unless otherwise specified, "a plurality of" means two or more than two.

In the descriptions of some embodiments, expressions of "connection" and extensions thereof may be used. For example, when some embodiments are described, the term "connection" may be used to indicate that two or more components are in direct physical contact or electrical contact with each other. Embodiments of this application herein are not necessarily limited to content of this specification.

"A and/or B" includes the following three combinations: only A, only B, and a combination of A and B.

The use of "configured to" in this specification implies an open and inclusive language, and does not exclude a device that is applicable to or configured to perform an additional task or step.

In addition, the use of "based on" means openness and inclusiveness, since processes, steps, calculation, or other actions "based on" one or more of conditions or values may be based in practice on additional conditions or values outside the described values.

In the content of this application, the meanings of "on", "above", and "on the top of" should be interpreted in a broadest manner, so that "on" means not only "directly on something", but also includes the meaning of "on something" with an intermediate feature or layer between associated objects, and "above" or "on the top of" not only means "above" or "on the top of" something, but also includes the meaning of being "above" or "on the top of" something (that is, directly on something) without an intermediate feature or layer between the associated objects.

Some embodiments of this application provide an electronic device. The electronic device may be, for example, an apparatus having an image capturing function like a camera, an internet protocol camera (Internet Protocol Camera, IPC), a mobile phone having a front-facing camera and/or a rear-facing camera, a tablet having a front-facing camera and/or a rear-facing camera, a digital camera, a digital video camera, a vehicle-mounted camera, or an industrial camera. The electronic device may be applied to the security protection field, the photographing field, the automotive electronics field, the industrial machine vision field, or the like.

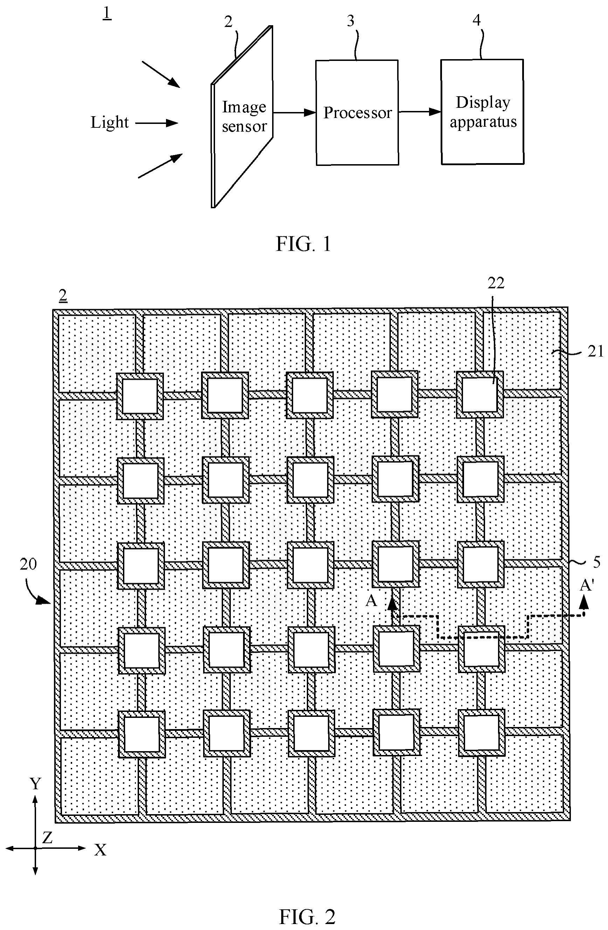

FIG. 1 is a diagram of a structure of the electronic device according to an embodiment of this application.

As shown in FIG. 1, an electronic device 1 may include an image sensor 2 and a processor 3. The image sensor 2 is configured to convert a received optical image into a digital image signal. The processor 3 is electrically connected to the image sensor 2, and is configured to receive the digital image signal from the image sensor 2, and process the digital image signal.

For example, the electronic device 1 further includes a display apparatus 4. The display apparatus 4 is electrically connected to the processor 3. The display apparatus 4 may display, under control of the processor 3 based on the digital image signal, an image corresponding to the digital image signal.

As one of core sensors for human perception of the world, an image sensor has been playing an important role in the human society. With development of image sensor technologies, the image sensor includes a charge-coupled device (Charge-Coupled Device, CCD) image sensor, a complementary metal oxide semiconductor image sensor (CMOS Image Sensor, CIS), a quantum image sensor (Quantum Image Sensor, QIS), a quantum dot image sensor (Quantum Dot Image Sensor, QDIS), and a single photon avalanche diode (Single Photon Avalanche Diode, SPAD) image sensor.

Core performance of the image sensor includes low-illumination performance and a high dynamic range (High Dynamic Range, HDR). The "low-illumination performance" refers to a light detection capability of the image sensor in a low light intensity. The "high dynamic range" refers to a large difference between a maximum light intensity and a minimum light intensity that are simultaneously detected in a same frame of image.

In recent years, the SPAD image sensor gradually attracts attention in the field. The SPAD image sensor has single-photon-level light detection sensitivity in an environment with a low illumination range, and therefore has good low-illumination performance.

The SPAD image sensor quantifies a single photon through counting. A quantization process includes dead time, so that there is a non-linear relationship between a count value of the SPAD image sensor and illumination. To be specific, as the illumination increases, a counting capability of the SPAD image sensor decreases. In a case of large illumination (a large quantity of single photons), a light detection capability of the SPAD image sensor decreases, or even the SPAD image sensor cannot respond. Therefore, the SPAD image sensor does not have a high dynamic range.

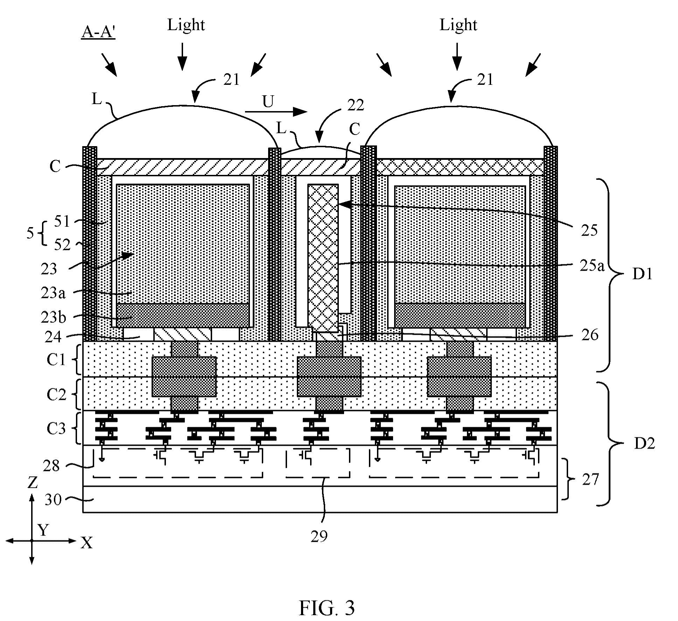

To resolve the foregoing problem, some embodiments of this application provide an image sensor. FIG. 2 is a diagram of a planar structure of an image sensor according to an embodiment of this application. FIG. 3 is a sectional view of the image sensor in FIG. 2 along a section line A-A'.

As shown in FIG. 2, the image sensor 2 includes a pixel array structure 20, and the pixel array structure 20 includes a plurality of first photoelectric detection pixel structures 21 and a plurality of second photoelectric detection pixel structures 22.

For example, the first photoelectric detection pixel structure 21 may include an SPAD pixel structure, and the second photoelectric detection pixel structure 22 may include at least one of a CIS pixel structure, a QIS pixel structure, a QDIS pixel structure, and a non-silicon-based image sensor pixel structure.

As shown in FIG. 2 and FIG. 3, the pixel array structure 20 includes a first photosensitive device 23, a first pixel circuit 24, a second photosensitive device 25, a second pixel circuit 26, and a processing circuit 27. Each first photoelectric detection pixel structure 21 includes at least one first photosensitive device 23, and each second photoelectric detection pixel structure 22 includes at least one second photosensitive device 25.

The first photosensitive device 23 receives light, and generates and outputs a first electrical signal. The second photosensitive device 25 receives light, and generates and outputs a second electrical signal.

A plurality of first photosensitive devices 23 are arranged in an array, and the first pixel circuit 24 is electrically connected to the first photosensitive device 23. A plurality of second photosensitive devices 25 are arranged in an array, and the second pixel circuit 26 is electrically connected to the second photosensitive device 25. The first pixel circuit 24 and the second pixel circuit 26 are electrically connected to the processing circuit 27 separately.

The first pixel circuit 24 receives the first electrical signal from the first photosensitive device 23, and the second pixel circuit 26 receives the second electrical signal from the second photosensitive device 25. The processing circuit 27 receives the first electrical signal, generates and outputs a first image signal; and receives the second electrical signal, and generates and outputs a second image signal.

A structure of the first photosensitive device 23 is different from a structure of the second photosensitive device 25, and photosensitive characteristics of the first photosensitive device 23 and the second photosensitive device 25 are also different. For example, when the first photoelectric detection pixel structure 21 includes an SPAD pixel structure, the first photosensitive device 23 may include a single photon avalanche diode; and when the second photoelectric detection pixel structure 22 includes a CIS pixel structure, the second photosensitive device 25 may include a photodiode (Photodiode, PD). The second photosensitive device 25 may alternatively include a quantum dot image sensor.

As shown in FIG. 3, the first photosensitive device 23 and the second photosensitive device 25 are adjacently disposed, the pixel array structure 20 further includes an isolation structure 5, and the isolation structure 5 is disposed between the first photosensitive device 23 and the second photosensitive device 25.

The image sensor 2 provided in the foregoing embodiments of this application includes the first photosensitive device 23, the first pixel circuit 24, the second photosensitive device 25, the second pixel circuit 26, and the processing circuit 27. When the first photosensitive device 23 includes the single photon avalanche diode, the single photon avalanche diode has a strong light detection capability in an environment with a low illumination range, and is applicable to detecting light in the low illumination range. This helps improve low-illumination performance of the image sensor 2.

When the second photosensitive device 25 includes the photodiode, the photodiode has a strong light detection capability in an environment with a high illumination range, and is applicable to detecting light in the high illumination range. A combination of the two types of photosensitive devices makes the image sensor 2 have a high dynamic range and improves a capability of the image sensor to detect all ambient light.

In addition, the isolation structure 5 is disposed between the first photosensitive device 23 and the second photosensitive device 25. The isolation structure 5 may block photon and charge migration between the first photosensitive device and the second photosensitive device, to avoid particle-level crosstalk between the first photosensitive device and the second photosensitive device, and further improve low-illumination performance and a dynamic range of the image sensor 2.

In some embodiments, with reference to FIG. 2 and FIG. 3, each first photosensitive device 23 is surrounded by the plurality of second photosensitive devices 25, and each second photosensitive device 25 is surrounded by the plurality of first photosensitive devices 23.

In the foregoing disposing manner, the first photosensitive devices 23 and the second photosensitive devices 25 are nested in each other, and are periodically and regularly arranged, so that the plurality of first photosensitive devices 23 in the image sensor 2 are evenly arranged, and the plurality of second photosensitive devices 25 are evenly arranged. This helps improve detection precision of the image sensor 2 for light in each illumination range.

In some embodiments, as shown in FIG. 2 and FIG. 3, an example in which the first photosensitive device 23 includes the single photon avalanche diode is used. The processing circuit 27 includes a first signal preprocessing circuit 28. The first photoelectric detection pixel structure 21 includes the single photon avalanche diode, the first pixel circuit 24, and the first signal preprocessing circuit 28 that are connected in sequence.

A working principle of the first photoelectric detection pixel structure 21 is as follows: The single photon avalanche diode receives light, and generates and outputs the first electrical signal to the first pixel circuit 24. The first signal preprocessing circuit 28 receives the first electrical signal from the first pixel circuit 24, and generates and outputs a first digital signal.

For example, the single photon avalanche diode includes a first photosensitive absorption layer 23a and a multiplication layer 23b. The first photosensitive absorption layer 23a absorbs photons and generates electrons. The electrons quickly generate a large quantity of carriers in the multiplication layer 23b based on multiplication effect, that is, trigger an avalanche breakdown.

For example, the first pixel circuit 24 may be a gating circuit.

For example, the first signal preprocessing circuit 28 may include a quench (quench) circuit and a counter (counter). The avalanche breakdown of the single photon avalanche diode is a self-continuous behavior. If there is no external interference suppression, a current generated by the avalanche breakdown cannot be automatically cut off. A long-time high current causes the device to heat or even burn out, and the device cannot enter a new detection period. The quench circuit may be configured to reduce a bias voltage between positive and negative electrodes of the single photon avalanche diode, and make the bias voltage lower than an avalanche breakdown voltage, to block the avalanche breakdown.

When the avalanche breakdown occurs in the single photon avalanche diode, the counter may be configured to count the current generated by the avalanche breakdown, to generate a digital image signal.

For example, the first signal preprocessing circuit 28 may further include a fusion circuit, configured to perform fusion processing on digital image signals of a plurality of image frames, or perform fusion processing on exposure duration, to increase a dynamic range of light detection of the first photoelectric detection pixel structure 21.

The single photon avalanche diode is used as the first photosensitive device 23, so that the first photoelectric detection pixel structure 21 may perform light detection in the environment with the low illumination range. Imaging brightness of an electronic device 1 equipped with the first photoelectric detection pixel structure 21 is positively correlated with a photon detection probability of the first photoelectric detection pixel structure 21 and a total counting rate of the counter.

In addition, the first photoelectric detection pixel structure 21 generates the digital image signal in a manner of counting by the counter, and conversion from an analog image signal to a digital image signal is not required. Therefore, the pixel has low read noise, so that the first photoelectric detection pixel structure 21 has a high signal-to-noise ratio (Signal-to-Noise Ratio, SNR) in the environment with the low illumination range, and the first photoelectric detection pixel structure 21 has a strong low-illumination light detection capability.

Still refer to FIG. 2 and FIG. 3. An example in which the second photosensitive device 25 includes the photodiode is used. The processing circuit 27 further includes a second signal preprocessing circuit 29. The second photoelectric detection pixel structure 22 includes the photodiode, the second pixel circuit 26, the second signal preprocessing circuit 29 that are connected in sequence.

A working principle of the second photoelectric detection pixel structure 22 is as follows: The photodiode receives light, and generates and outputs the second electrical signal to the second pixel circuit 26. The second signal preprocessing circuit 29 receives the second electrical signal from the second pixel circuit 26, and generates and outputs a second digital signal.

The photodiode is a semiconductor device formed by a P-N junction, and has a unidirectional conductive characteristic. The photodiode has a second photosensitive absorption layer 25a. As light illumination continues, charges inside the photodiode are continuously accumulated, to convert an optical signal into an electrical signal. A charge accumulation is positively correlated with exposure duration of the photodiode and light intensity. The charge accumulation can be controlled by controlling the exposure duration.

For example, the second pixel circuit 26 may include a correlated double sampling (Correlated Double Sampling, CDS) circuit, a programmable gain amplifier (Programmable Gain Amplifier, PGA), and an analog to digital converter (Analog to Digital Converter, ADC) that are connected in sequence.

The correlated double sampling circuit may obtain an analog image signal based on the electrical signal generated by the photodiode, and a voltage value of the analog image signal is positively correlated with a product of the exposure duration and the light intensity. The programmable gain amplifier is configured to perform linear amplification on the analog image signal, that is, provide an analog gain, to meet an input swing requirement of the analog to digital converter. The analog to digital converter is configured to convert the amplified analog image signal into a digital image signal.

For example, the second signal preprocessing circuit 29 may include a fusion circuit, configured to perform fusion processing on digital image signals of a plurality of image frames, or perform fusion processing on the exposure duration. In addition, the second signal preprocessing circuit 29 may further process a digital image signal that is exposed once and read twice, to increase a dynamic range of light detection of the second photoelectric detection pixel structure 22.

The photodiode is used as the second photosensitive device 25, so that according to a charge accumulation principle, the second photoelectric detection pixel structure 22 is suitable for light detection in high illumination. The imaging brightness of the electronic device 1 equipped with the second photoelectric detection pixel structure 22 is positively correlated with the charge accumulation.

In the foregoing embodiments, a combination of the single photon avalanche diode and the photodiode is used. The first photoelectric detection pixel structure 21 is applicable to detecting light in the low illumination range, and the second photoelectric detection pixel structure 22 is applicable to detecting light in the high illumination range. In this way, not only low-illumination performance of the image sensor 2 is improved, but also the image sensor 2 has a high dynamic range.

As mentioned above, the isolation structure 5 is disposed between the first photosensitive device 23 and the second photosensitive device 25. It may be understood that, when the first photosensitive device 23 includes the single photon avalanche diode and the second photosensitive device 25 includes the photodiode, charges are accumulated inside the photodiode. If the charges are migrated to the single photon avalanche diode, a large quantity of carriers are generated based on the multiplication effect, triggering the avalanche breakdown.

In view of this, the isolation structure 5 is disposed between the first photosensitive device 23 and the second photosensitive device 25, and the isolation structure 5 may block photon and charge migration between the first photosensitive device 23 and the second photosensitive device 25, to avoid particle-level crosstalk between the first photosensitive device 23 and the second photosensitive device 25.

In some embodiments, with reference to FIG. 2 and FIG. 3, the plurality of first photosensitive devices 23 are adjacently disposed, and the isolation structure 5 is further disposed between the adjacent first photosensitive devices 23, so that the adjacent first photosensitive devices 23 may be separated, to avoid particle-level crosstalk between the first photosensitive devices 23.

For example, the isolation structure 5 includes a doping layer 51 and an isolation layer 52 that are arranged in a first direction U, where the first direction U is a direction from the first photosensitive device 23 to the second photosensitive device 25.

For example, the isolation structure 5 includes two doping layers 51 and one isolation layer 52 that are arranged in the first direction U. The two doping layers 51 are respectively located on two sides of the isolation layer 52. An isolation capability of the isolation structure 5 is improved by disposing a plurality of layer structures.

A material of the doping layer 51 is doped with ions. For example, the material of the doping layer 51 is doped with P-type ions.

For example, the material of the isolation layer 52 includes a dielectric material, and the dielectric material includes at least one of silicon oxide, silicon nitride, silicon oxynitride, hafnium oxide, and aluminum oxide.

For another example, the material of the isolation layer 52 includes a metal material, and the metal material includes at least one of Au, Ti, Al, W, Cu, Ni, Pt, and Pd.

For another example, the material of the isolation layer 52 may include both a dielectric material and a metal material.

In addition, the material of the isolation layer 52 may be a material that absorbs light or has a strong light reflection capability, to avoid a crosstalk problem caused by light propagation between the first photosensitive devices 23 and between the first photosensitive device 23 and the second photosensitive device 25.

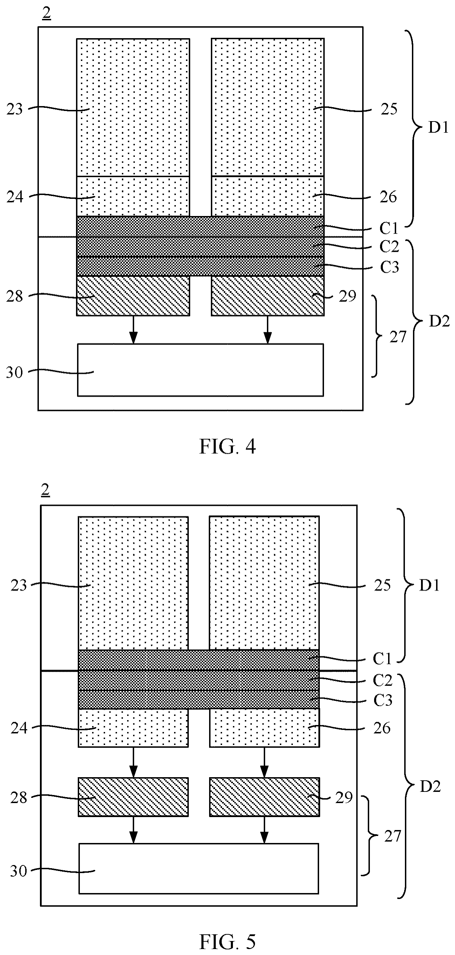

FIG. 4 is a brief diagram of a structure of the image sensor in FIG. 3.

Refer to FIG. 3 and FIG. 4. The image sensor 2 includes a first chip D1 and a second chip D2 that are disposed in a stack manner, and the processing circuit 27 further includes an image signal processing (Image Signal Processing, ISP) circuit 30. The first photosensitive device 23, the first pixel circuit 24, the second photosensitive device 25, and the second pixel circuit 26 are disposed on the first chip D1. The first signal preprocessing circuit 28, the second signal preprocessing circuit 29, and the image signal processing circuit 30 are disposed on the second chip D2.

For example, the first chip D1 further includes a first interconnection layer C1. The first photosensitive device 23, the first pixel circuit 24, and the first interconnection layer C1 are connected in sequence, and the second photosensitive device 25, the second pixel circuit 26, and the first interconnection layer C1 are connected in sequence.

For example, the second chip D2 further includes a second interconnection layer C2 and a redistribution layer C3. The second interconnection layer C2, the redistribution layer C3, the first signal preprocessing circuit 28, and the image signal processing circuit 30 are connected in sequence, and the second interconnection layer C2, the redistribution layer C3, the second signal preprocessing circuit 29, and the image signal processing circuit 30 are connected in sequence.

For example, the first chip D1 is bonded with the second interconnection layer C2 of the second chip D2 through the first interconnection layer C1, to implement an electrical connection between the first chip D1 and the second chip D2.

In some embodiments, as shown in FIG. 3, the image sensor 2 further includes a plurality of optical lenses L, and the plurality of optical lenses L are disposed on a side that is of the first chip D1 and that is away from the second chip D2.

Each first photoelectric detection pixel structure 21 includes one first photosensitive device 23, and each first photosensitive device 23 corresponds to one optical lens L. Each second photoelectric detection pixel structure 22 includes one second photosensitive device 25, and each second photosensitive device 25 corresponds to one optical lens L.

In the foregoing embodiments, the optical lens L may be configured to converge light, so that more light is incident to the first photoelectric detection pixel structure 21 and the second photoelectric detection pixel structure 22. This helps increase light detection amounts of the first photosensitive device 23 and the second photosensitive device 25.

In some embodiments, as shown in FIG. 3, the image sensor 2 further includes a plurality of color filter (Color Filter, CF) layers C, and the plurality of color filter layers C are disposed on the side that is of the first chip D1 and that is away from the second chip D2.

Each first photoelectric detection pixel structure 21 includes one first photosensitive device 23, and each first photosensitive device 23 corresponds to one color filter layer C. Each second photoelectric detection pixel structure 22 includes one second photosensitive device 25, and each second photosensitive device 25 corresponds to one color filter layer C.

In the foregoing embodiments, the color filter layer C may be configured to filter specific color light from ambient light, so that the color light can be incident through the color filter layer C, to be detected by the first photosensitive device 23 and the second photosensitive device 25. A processor 3 receives a digital image signal from the image sensor 2, to control a display apparatus 4 to display a color image.

For example, the color filter layer C may be located between the optical lens L and the first chip D1.

For example, colors of the plurality of color filter layers C include red (red), green (green), and blue (blue).

For example, in the plurality of color filter layers C, red occupies 1/4, green occupies 1/2, and blue occupies 1/4. In other words, the plurality of color filter layers C are disposed in an RGGB Bayer (Bayer) array.

For example, colors of the plurality of color filter layers C include red (red), yellow (yellow), and blue (blue).

For example, in the plurality of color filter layers C, red occupies 1/4, yellow occupies 1/2, and blue occupies 1/4. In other words, the plurality of color filter layers C are disposed in an RYYB array.

FIG. 5 is a brief diagram of a structure of another image sensor according to an embodiment of this application.

As shown in FIG. 5, the first photosensitive device 23 and the second photosensitive device 25 are disposed on the first chip D1, and the first pixel circuit 24, the first signal preprocessing circuit 28, the second pixel circuit 26, the second signal preprocessing circuit 29, and the image signal processing circuit 30 are disposed on the second chip D2.

The first pixel circuit 24 and the second pixel circuit 26 are transferred from the first chip D1 to the second chip D2, helping reduce a thickness of the first chip D1.

For example, the first chip D1 further includes a first interconnection layer C1, the first photosensitive device 23 is connected to the first interconnection layer C1, and the second photosensitive device 25 is connected to the first interconnection layer C1.

For example, the second chip D2 further includes a second interconnection layer C2 and a redistribution layer C3. The second interconnection layer C2, the redistribution layer C3, the first pixel circuit 24, the first signal preprocessing circuit 28, and the image signal processing circuit 30 are connected in sequence, and the second interconnection layer C2, the redistribution layer C3, the second pixel circuit 26, the second signal preprocessing circuit 29, and the image signal processing circuit 30 are connected in sequence.

For example, the first chip D1 is bonded with the second interconnection layer C2 of the second chip D2 through the first interconnection layer C1, to implement an electrical connection between the first chip D1 and the second chip D2.

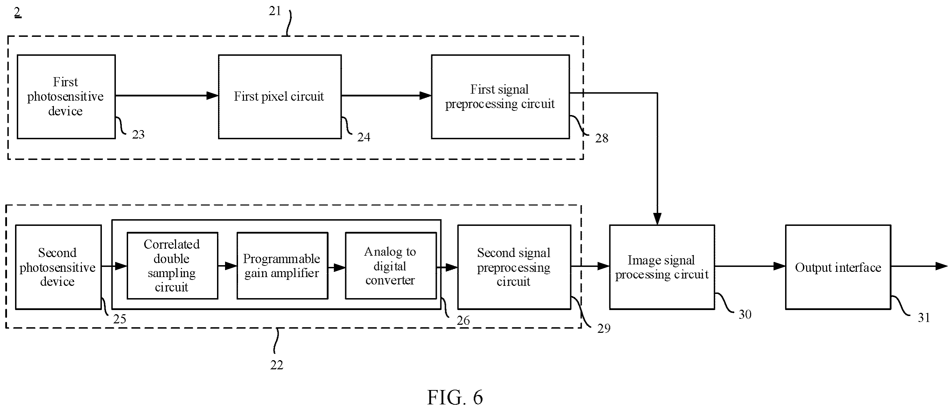

FIG. 6 to FIG. 8 are block diagrams of structures of a plurality of image sensors according to an embodiment of this application.

As shown in FIG. 6, the processing circuit 27 further includes an output interface 31. The first photosensitive device 23, the first pixel circuit 24, the first signal preprocessing circuit 28, the image signal processing circuit 30, and the output interface 31 are electrically connected in sequence. In other words, the first photoelectric detection pixel structure 21, the image signal processing circuit 30, and the output interface 31 are electrically connected in sequence.

The second photosensitive device 25, the second pixel circuit 26, the second signal preprocessing circuit 29, the image signal processing circuit 30, and the output interface 31 are electrically connected in sequence. In other words, the second photoelectric detection pixel structure 22, the image signal processing circuit 30, and the output interface 31 are electrically connected in sequence.

The image signal processing circuit 30 may receive a first digital signal from the first photoelectric detection pixel structure 21, and the image signal processing circuit 30 is configured to compile or filter the first digital signal, to generate a first digital image signal. The image signal processing circuit 30 further receives a second digital signal from the second photoelectric detection pixel structure 22, and compiles or filters the second digital signal, to generate a second digital image signal.

The output interface 31 is configured to receive the first digital image signal from the image signal processing circuit 30, and output the first digital image signal. The output interface 31 is further configured to receive the second digital image signal from the image signal processing circuit 30, and output the second digital image signal.

For example, the image signal processing circuit 30 may further include an HDR circuit, which may be configured to improve a dynamic range of the image sensor 2.

For example, the output interface 31 may be electrically connected to the processor 3, and is configured to transmit the first digital image signal to the processor 3, and transmit the second digital image signal to the processor 3.

In the foregoing embodiments, the image sensor 2 may implement separate output (dual-stream output) of the first photoelectric detection pixel structure 21 and the second photoelectric detection pixel structure 22, and separately output the first digital image signal and the second digital image signal to the processor 3 through the output interface 31, to provide support of source signals (the first digital image signal and the second digital image signal) for a high dynamic range of the image sensor 2, and make a processing procedure of the image sensor 2 lightweight.

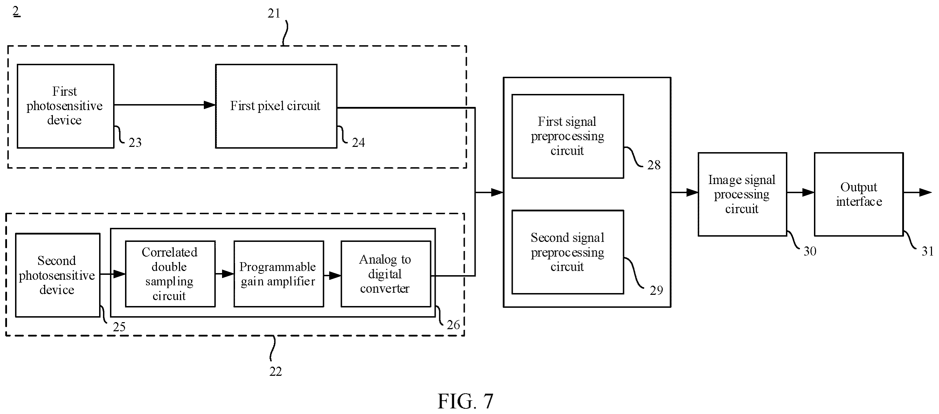

In some embodiments, as shown in FIG. 7, the first signal preprocessing circuit 28 of the first photoelectric detection pixel structure 21 and the second signal preprocessing circuit 29 of the second photoelectric detection pixel structure 22 may be integrated into a same circuit, to reduce an occupied area of the circuit. When both the first signal preprocessing circuit 28 and the second signal preprocessing circuit 29 are disposed on the second chip D2, a size of the second chip D2 is miniaturized.

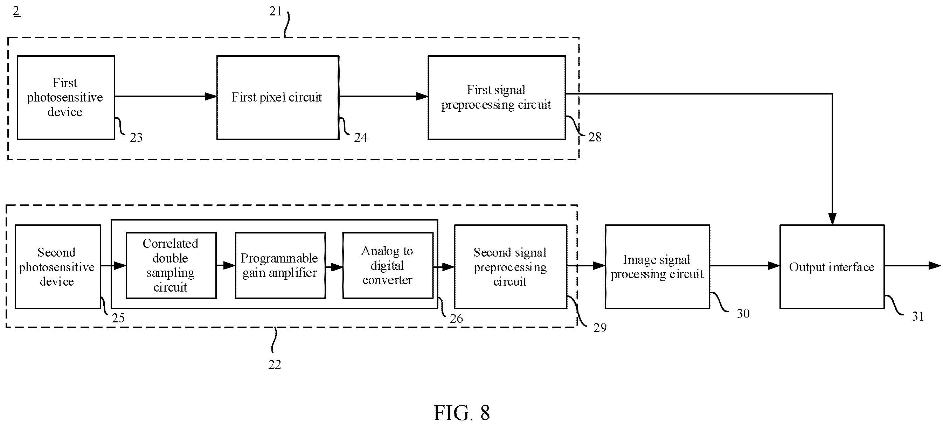

In some embodiments, as shown in FIG. 8, the first photosensitive device 23, the first pixel circuit 24, the first signal preprocessing circuit 28, and the output interface 31 are electrically connected in sequence. In other words, the first photoelectric detection pixel structure 21 is directly connected to the output interface 31.

The second photosensitive device 25, the second pixel circuit 26, the second signal preprocessing circuit 29, the image signal processing circuit 30, and the output interface 31 are electrically connected in sequence. In other words, the second photoelectric detection pixel structure 22, the image signal processing circuit 30, and the output interface 31 are electrically connected in sequence.

In this case, the first digital signal output by the first photoelectric detection pixel structure 21 may be directly output through the output interface 31 without passing through the image signal processing circuit 30. The image signal processing circuit 30 receives only the second digital signal from the second photoelectric detection pixel structure 22, and the image signal processing circuit 30 is configured to compile or filter the second digital signal, to generate a second digital image signal.

The output interface 31 is configured to receive and output the first digital signal, where the first digital signal includes a first digital image signal. The output interface 31 is further configured to receive the second digital image signal from the image signal processing circuit 30, and output the second digital image signal.

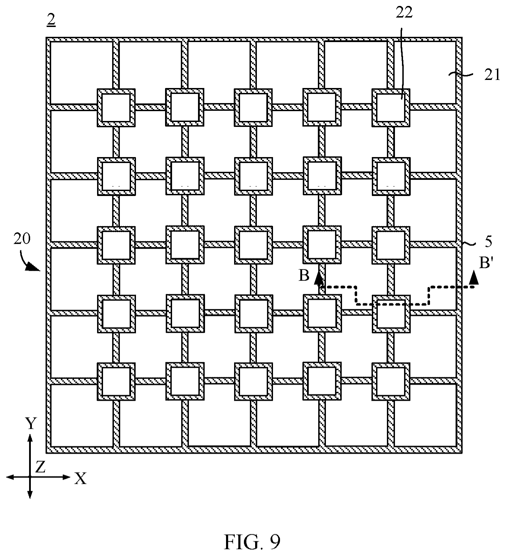

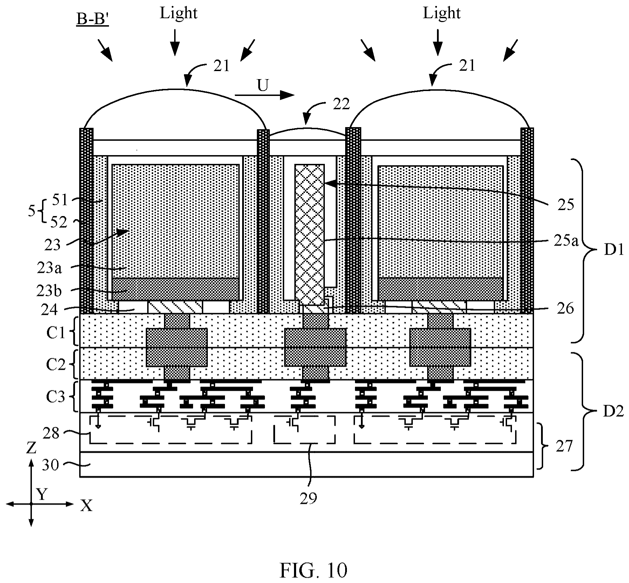

FIG. 9 is a diagram of a planar structure of another image sensor according to an embodiment of this application. FIG. 10 is a sectional view of the image sensor in FIG. 9 along a section line B-B'.

As shown in FIG. 9 and FIG. 10, no color filter layer is disposed in the image sensor 2. In this case, the first photoelectric detection pixel structure 21 and the second photoelectric detection pixel structure 22 directly detect ambient light, generate digital signals, and transmit digital image signals to the processor 3 through the output interface 31, to control the display apparatus 4 to display a black-and-white image.

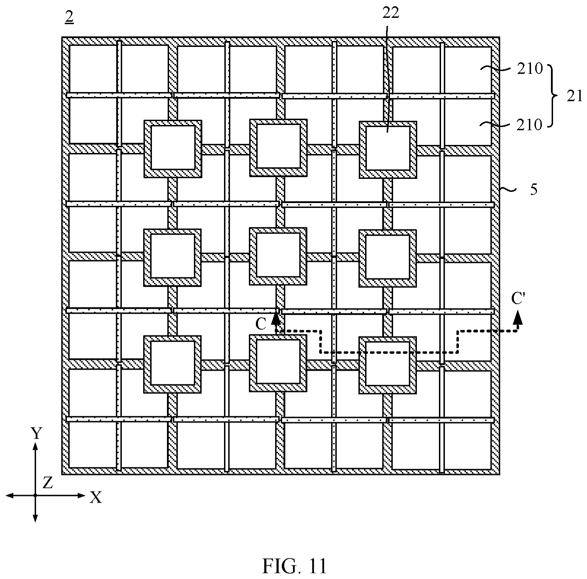

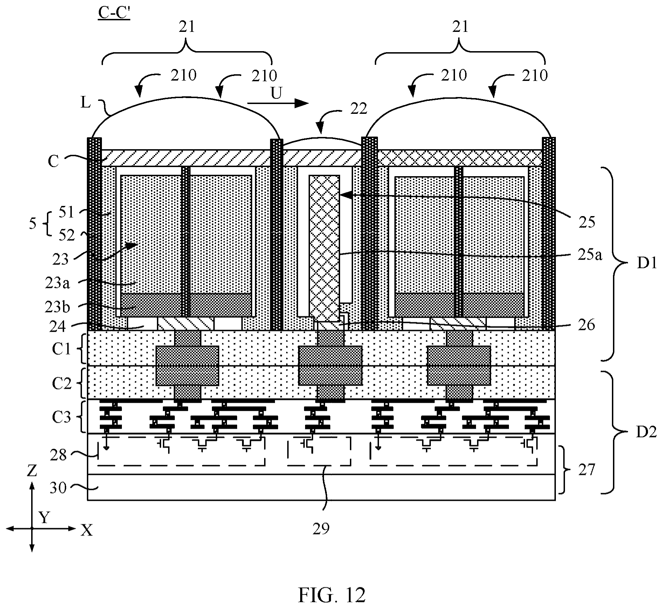

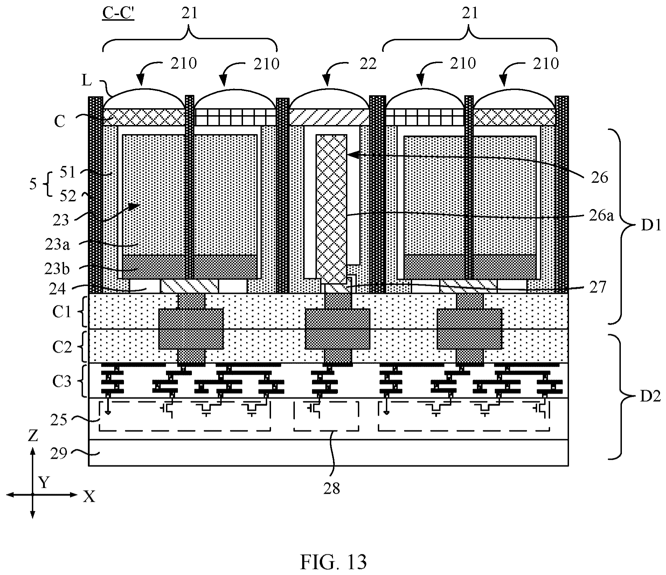

FIG. 11 is a diagram of a planar structure of another image sensor according to an embodiment of this application. FIG. 12 is a sectional view of the image sensor in FIG. 11 along a section line C-C'. FIG. 13 is another sectional view of the image sensor in FIG. 11 along the section line C-C'.

As shown in FIG. 11 and FIG. 12, each first photoelectric detection pixel structure 21 includes a plurality of first photoelectric detection sub-pixel structures 210. In other words, each first photoelectric detection pixel structure 21 is split into a plurality of first photoelectric detection sub-pixel structures 210, which is equivalent to increasing a quantity of first photoelectric detection pixel structures 21.

Each first photoelectric detection sub-pixel structure 210 includes one first photosensitive device 23, that is, each first photoelectric detection pixel structure 21 includes a plurality of first photosensitive devices 23.

It may be understood that, compared with the second photoelectric detection pixel structure 22, the first photoelectric detection pixel structure 21 has a stronger light detection capability in the environment with the low illumination range. Based on this, increasing the quantity of first photoelectric detection pixel structures 21 helps improve low-illumination performance of the image sensor 2.

For example, each first photoelectric detection pixel structure 21 may be split into 2×2 first photoelectric detection sub-pixel structures 210, or may be split into 4×4 first photoelectric detection sub-pixel structures 210, or may be split into 8×8 first photoelectric detection sub-pixel structures 210. This is not limited in embodiments of this application.

In some embodiments, as shown in FIG. 12, in each first photoelectric detection pixel structure 21, a plurality of first photosensitive devices 23 correspond to one optical lens L. In each second photoelectric detection pixel structure 22, each second photosensitive device 25 corresponds to one optical lens L.

In the foregoing embodiments, a plurality of first photosensitive devices 23 in a same first photoelectric detection pixel structure 21 correspond to one optical lens L, and the optical lens L may be configured to converge light, so that more light is incident to the first photoelectric detection pixel structure 21 and the second photoelectric detection pixel structure 22. This helps increase light detection amounts of the first photosensitive device 23 and the second photosensitive device 25.

In some embodiments, as shown in FIG. 13, in each first photoelectric detection sub-pixel structure 210, each first photosensitive device 23 corresponds to one optical lens L.

In the foregoing embodiments, each first photosensitive device 23 corresponds to one optical lens L, to increase light incident to each first photoelectric detection sub-pixel structure 210, so as to increase the light detection amount of the first photosensitive device 23.

In some embodiments, as shown in FIG. 13, in each first photoelectric detection sub-pixel structure 210, each first photosensitive device 23 corresponds to one color filter layer C. In each second photoelectric detection pixel structure 22, each second photosensitive device 25 corresponds to one color filter layer C.

In the foregoing embodiments, the color filter layer C may be configured to filter specific color light from ambient light, so that the color light can be incident through the color filter layer C, to be detected by the first photosensitive device 23 in each first photoelectric detection sub-pixel structure 210 and by the second photosensitive device 25 in each second photoelectric detection pixel structure 22. The processor 3 receives a digital image signal from the image sensor 2, to control the display apparatus 4 to display a color image.

In some other embodiments, in each first photoelectric detection pixel structure 21, the plurality of first photosensitive devices 23 in the plurality of first photoelectric detection sub-pixel structures 210 correspond to one color filter layer C, so that the plurality of first photosensitive devices 23 detect color light from the same color filter layer C.

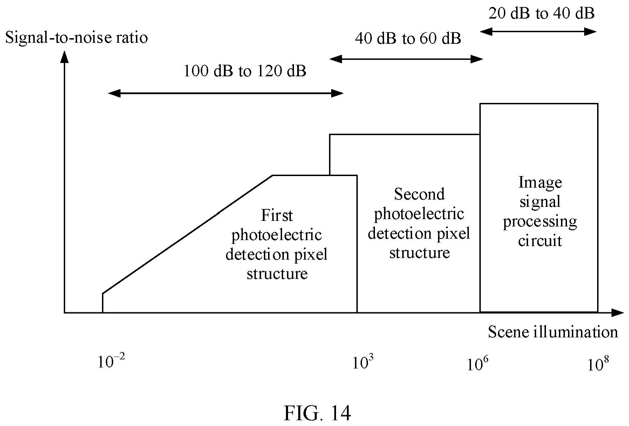

To verify high dynamic range performance of the image sensor 2 provided in some embodiments of this application, the inventor of this application performs a dynamic range test experiment on the image sensor 2. FIG. 14 is a diagram of a high dynamic range result of the image sensor according to an embodiment of this application.

As shown in FIG. 14, a horizontal coordinate is scene illumination (Scene illumination), and a vertical coordinate is a signal-to-noise ratio (SNR). It can be learned that, the first photoelectric detection pixel structure 21 is an SPAD pixel structure, and the SPAD pixel structure is applicable to detecting light in the low illumination range; and the second photoelectric detection pixel structure 22 is a CIS pixel structure, and the CIS pixel structure is applicable to detecting light in the high illumination range. A dynamic range of the SPAD pixel structure is 100 dB to 120 dB, and a dynamic range of the CIS pixel structure is 40 dB to 60 dB. After the two structures are combined, the image sensor 2 has a high dynamic range.

In addition, the HDR circuit in the image signal processing (ISP) circuit 30 may further increase the dynamic range of the image sensor 2 by 20 dB to 40 dB, to further broaden the dynamic range of the image sensor 2.

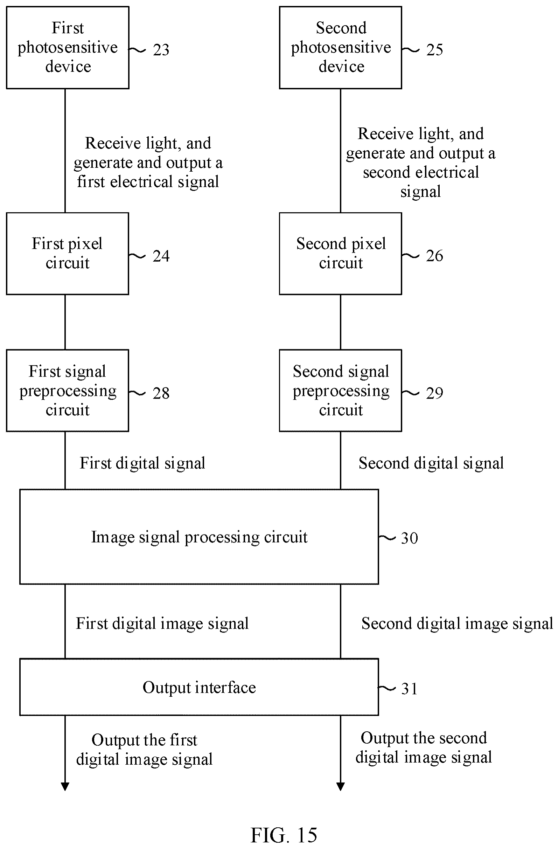

Some embodiments of this application further provide an image capturing method. The image capturing method may be applied to the image sensor in any one of the foregoing embodiments. FIG. 15 is a flowchart of the image capturing method according to an embodiment of this application.

As shown in FIG. 15, an image sensor 2 includes a first photosensitive device 23 and a second photosensitive device 25, and the image capturing method includes the following steps:
the first photosensitive device 23 receives light, and generates and outputs a first electrical signal to a first pixel circuit 24; and the second photosensitive device 25 receives light, and generates and outputs a second electrical signal to a second pixel circuit 26.

According to the image capturing method provided in the foregoing embodiments of this application, the first photosensitive device 23 receives the light, and generates and outputs the first electrical signal to the first pixel circuit 24. When the first photosensitive device 23 includes a single photon avalanche diode, the single photon avalanche diode has a strong light detection capability in an environment with a low illumination range, and is applicable to detecting light in the low illumination range. This helps improve low-illumination performance of the image sensor 2.

In addition, the second photosensitive device 25 receives the light, and generates and outputs the second electrical signal to the second pixel circuit 26. When the second photosensitive device 25 includes a photodiode, the photodiode has a strong light detection capability in an environment with a high illumination range, and is applicable to detecting light in the high illumination range. A combination of the two types of photosensitive devices makes the image sensor 2 have a high dynamic range and improves a capability of the image sensor to detect all ambient light.

In some embodiments, as shown in FIG. 15, a first signal preprocessing circuit 28 is electrically connected to the first pixel circuit 24, a second signal preprocessing circuit 29 is electrically connected to the second pixel circuit 26, and the image capturing method further includes the following steps:
the first signal preprocessing circuit 28 receives the first electrical signal from the first pixel circuit 24, and generates and outputs a first digital signal; and the second signal preprocessing circuit 29 receives the second electrical signal from the second pixel circuit 26, and generates and outputs a second digital signal.

In some embodiments, as shown in FIG. 15, both the first signal preprocessing circuit 28 and the second signal preprocessing circuit 29 are electrically connected to an image signal processing circuit 30, the image signal processing circuit 30 is electrically connected to an output interface 31, and the image capturing method further includes the following steps:
the image signal processing circuit 30 filters the first digital signal to generate a first digital image signal, and the output interface 31 receives and outputs the first digital image signal; and
the image signal processing circuit 30 filters the second digital signal to generate a second digital image signal, and the output interface 31 receives and outputs the second digital image signal.

In the foregoing embodiments, the image signal processing circuit 30 may compile or filter the first digital signal to generate the first digital image signal, and compile or filter the second digital signal to generate the second digital image signal, to reduce noise in the first digital image signal and the second digital image signal.

The output interface 31 is configured to receive the first digital image signal from the image signal processing circuit 30, and output the first digital image signal. The output interface 31 is further configured to receive the second digital image signal from the image signal processing circuit 30, and output the second digital image signal.

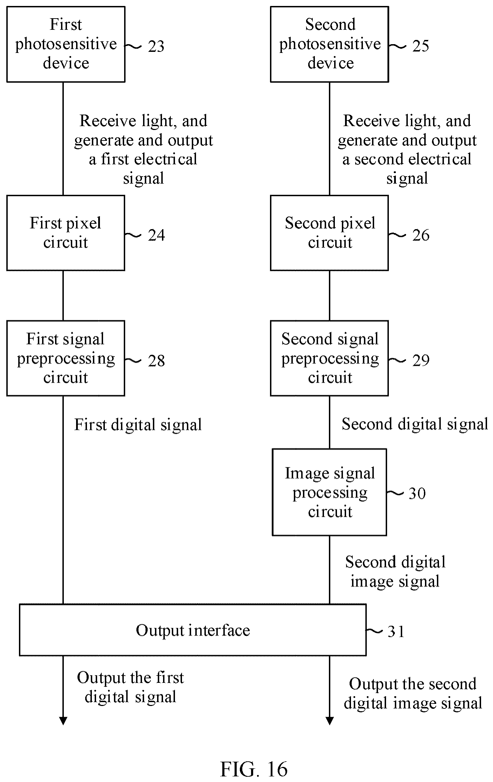

FIG. 16 is another flowchart of the image capturing method according to an embodiment of this application.

As shown in FIG. 16, the first signal preprocessing circuit 28 is directly connected to the output interface 31, the second signal preprocessing circuit 29, the image signal processing circuit 30, and the output interface 31 are electrically connected in sequence, and the image capturing method includes the following steps:
the output interface 31 receives a first digital signal, and outputs the first digital signal, where the first digital signal includes a first digital image signal; and
the image signal processing circuit 30 filters the second digital signal to generate a second digital image signal, and the output interface 31 receives and outputs the second digital image signal.

It may be understood that the first signal preprocessing circuit 28 includes a counter, the first digital signal is generated in a manner of counting by the counter, and conversion from an analog signal to a digital signal is not required. Therefore, the first digital signal has low noise, and does not need to be compiled or filtered by the image signal processing circuit 30, and the first digital signal may be directly output as the first digital image signal.

The image signal processing circuit 30 may compile or filter the second digital signal, to generate the second digital image signal, so as to reduce noise in the second digital image signal. The output interface 31 is configured to receive the second digital image signal from the image signal processing circuit 30, and output the second digital image signal.

Some embodiments of this application provide an image sensor, an image capturing method, and an electronic device. The image sensor includes a first photosensitive device, a first pixel circuit, a second photosensitive device, a second pixel circuit, and a processing circuit. When the first photosensitive device includes a single photon avalanche diode, the single photon avalanche diode has a strong light detection capability in an environment with a low illumination range, and is applicable to detecting light in the low illumination range. This helps improve low-illumination performance of the image sensor.

When the second photosensitive device includes a photodiode, the photodiode has a strong light detection capability in an environment with a high illumination range, and is applicable to detecting light in the high illumination range. A combination of the two types of photosensitive devices makes the image sensor have a high dynamic range and improves a capability of the image sensor to detect all ambient light.

In addition, an isolation structure is disposed between the first photosensitive device and the second photosensitive device. The isolation structure may block photon and charge migration between the first photosensitive device and the second photosensitive device, to avoid particle-level crosstalk between the first photosensitive device and the second photosensitive device, and further improve low-illumination performance and a dynamic range of the image sensor.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. An image sensor, comprising a pixel array structure and a processing circuit, wherein
the pixel array structure comprises:
a plurality of first photosensitive devices arranged in an array;
a first pixel circuit, electrically connected to the first photosensitive device;
a plurality of second photosensitive devices arranged in an array;
a second pixel circuit, electrically connected to the second photosensitive device; and
an isolation structure, wherein the first photosensitive device and the second photosensitive device are adjacently disposed, and the isolation structure is disposed between the first photosensitive device and the second photosensitive device, wherein
a structure of the first photosensitive device is different from a structure of the second photosensitive device; and
the first pixel circuit and the second pixel circuit are electrically connected to the processing circuit separately.

2. The image sensor according to claim 1, wherein the first photosensitive device comprises a single photon avalanche diode; and
the second photosensitive device comprises a photodiode or a quantum dot image sensor.

3. The image sensor according to claim 1 or 2, wherein the plurality of first photosensitive devices are adjacently disposed, and the isolation structure is further disposed between the adjacent first photosensitive devices.

4. The image sensor according to any one of claims 1 to 3, wherein the isolation structure comprises a doping layer and an isolation layer that are arranged in a first direction; and
the first direction is a direction from the first photosensitive device to the second photosensitive device.

5. The image sensor according to claim 4, wherein the isolation structure comprises two doping layers and one isolation layer that are arranged in the first direction, and the two doping layers are respectively located on two sides of the isolation layer.

6. The image sensor according to claim 4 or 5, wherein a material of the isolation layer comprises a dielectric material, and the dielectric material comprises at least one of silicon oxide, silicon nitride, silicon oxynitride, hafnium oxide, or aluminum oxide; and/or
the material of the isolation layer comprises a metal material, and the metal material comprises at least one of Au, Ti, Al, W, Cu, Ni, Pt, and Pd.

7. The image sensor according to any one of claims 1 to 6, wherein each first photosensitive device is surrounded by the plurality of second photosensitive devices, and each second photosensitive device is surrounded by the plurality of first photosensitive devices.

8. The image sensor according to any one of claims 1 to 7, wherein the pixel array structure comprises a plurality of first photoelectric detection pixel structures and a plurality of second photoelectric detection pixel structures;
each first photoelectric detection pixel structure comprises one first photosensitive device, or each first photoelectric detection pixel structure comprises a plurality of first photosensitive devices; and
each second photoelectric detection pixel structure comprises one second photosensitive device.

9. The image sensor according to claim 8, wherein the image sensor comprises a first chip and a second chip that are disposed in a stacked manner, and the processing circuit comprises an image signal processing circuit; and
the first photosensitive device, the first pixel circuit, the second photosensitive device, and the second pixel circuit are disposed on the first chip, and the image signal processing circuit is disposed on the second chip; or
the first photosensitive device and the second photosensitive device are disposed on the first chip, and the first pixel circuit, the second pixel circuit, and the image signal processing circuit are disposed on the second chip.

10. The image sensor according to claim 9, wherein the processing circuit further comprises a first signal preprocessing circuit, a second signal preprocessing circuit, and an output interface;
the first signal preprocessing circuit, the second signal preprocessing circuit, and the output interface are disposed on the second chip; and
the first photosensitive device, the first pixel circuit, the first signal preprocessing circuit, the image signal processing circuit, and the output interface are electrically connected in sequence, and the second photosensitive device, the second pixel circuit, the second signal preprocessing circuit, the image signal processing circuit, and the output interface are electrically connected in sequence; or
the first photosensitive device, the first pixel circuit, the first signal preprocessing circuit, and the output interface are electrically connected in sequence, and the second photosensitive device, the second pixel circuit, the second signal preprocessing circuit, the image signal processing circuit, and the output interface are electrically connected in sequence.

11. The image sensor according to claim 9 or 10, wherein the image sensor further comprises a plurality of optical lenses disposed on a side that is of the first chip and that is away from the second chip;
each first photoelectric detection pixel structure comprises one first photosensitive device, and each first photosensitive device corresponds to one optical lens; and
each second photosensitive device corresponds to one optical lens.

12. The image sensor according to claim 9 or 10, wherein the image sensor further comprises a plurality of optical lenses disposed on a side that is of the first chip and that is away from the second chip;
each first photoelectric detection pixel structure comprises a plurality of first photosensitive devices, and the plurality of first photosensitive devices correspond to one optical lens, or each first photosensitive device corresponds to one optical lens; and
each second photosensitive device corresponds to one optical lens.

13. The image sensor according to any one of claims 9 to 12, wherein the image sensor further comprises a plurality of color filter layers disposed on the side that is of the first chip and that is away from the second chip;
each first photoelectric detection pixel structure comprises one first photosensitive device, and each first photosensitive device corresponds to one color filter layer; and
each second photosensitive device corresponds to one color filter layer.

14. The image sensor according to any one of claims 9 to 12, wherein the image sensor further comprises a plurality of color filter layers disposed on the side that is of the first chip and that is away from the second chip;
each first photoelectric detection pixel structure comprises a plurality of first photosensitive devices, and the plurality of first photosensitive devices correspond to one color filter layer, or each first photosensitive device corresponds to one color filter layer; and
each second photosensitive device corresponds to one color filter layer.

15. The image sensor according to claim 13 or 14, wherein colors of the plurality of color filter layers comprise red, green, and blue, and the plurality of color filter layers are disposed in a Bayer array; or
colors of the plurality of color filter layers comprise red, yellow, and blue.

16. An image capturing method, wherein the image capturing method is applied to the image sensor according to any one of claims 1 to 15; and
the image capturing method comprises:
receiving, by the first photosensitive device, light, and generating and outputting a first electrical signal to the first pixel circuit; and
receiving, by the second photosensitive device, light, and generating and outputting a second electrical signal to the second pixel circuit.

17. The image capturing method according to claim 16, wherein the processing circuit comprises the first signal preprocessing circuit and the second signal preprocessing circuit, the first signal preprocessing circuit is electrically connected to the first pixel circuit, the second signal preprocessing circuit is electrically connected to the second pixel circuit, and the image capturing method further comprises:
receiving, by the first signal preprocessing circuit, the first electrical signal from the first pixel circuit, and generating and outputting a first digital signal; and
receiving, by the second signal preprocessing circuit, the second electrical signal from the second pixel circuit, and generating and outputting a second digital signal.

18. The image capturing method according to claim 17, wherein the processing circuit further comprises the image signal processing circuit and the output interface; and
both the first signal preprocessing circuit and the second signal preprocessing circuit are electrically connected to the image signal processing circuit, the image signal processing circuit is electrically connected to the output interface, and the image capturing method further comprises:
filtering, by the image signal processing circuit, the first digital signal to generate a first digital image signal;
receiving and outputting, by the output interface, the first digital image signal;
filtering, by the image signal processing circuit, the second digital signal to generate a second digital image signal; and
receiving and outputting, by the output interface, the second digital image signal.

19. The image capturing method according to claim 17, wherein the processing circuit further comprises the image signal processing circuit and the output interface; and
the first signal preprocessing circuit is directly connected to the output interface, the second signal preprocessing circuit, the image signal processing circuit, and the output interface are electrically connected in sequence, and the image capturing method further comprises:
receiving and outputting, by the output interface, the first digital signal, wherein the first digital signal comprises a first digital image signal;
filtering, by the image signal processing circuit, the second digital signal to generate a second digital image signal; and
receiving and outputting, by the output interface, the second digital image signal.

20. An electronic device, comprising:
the image sensor according to any one of claims 1 to 15; and
a processor, electrically connected to the image sensor.
